**Europäisches Patentamt**

(19) **European Patent Office**

**Office européen des brevets**

(11) Numéro de publication: **0 064 435**
**B1**

(12) # FASCICULE DE BREVET EUROPEEN

(45) Date de publication du fascicule du brevet:
**26.08.87**

(51) Int. Cl.⁴: **H 03 H 9/50,** H 03 H 9/48

(21) Numéro de dépôt: **82400668.8**

(22) Date de dépôt: **15.04.82**

(54) **Filtre électromécanique passe-bande à résonateurs couplés.**

(30) Priorité: **15.04.81 FR 8107632**

(43) Date de publication de la demande:
**10.11.82 Bulletin 82/45**

(45) Mention de la délivrance du brevet:
**26.08.87 Bulletin 87/35**

(84) Etats contractants désignés:
**DE GB IT NL**

(56) Documents cités:
**DE - B - 1 257 997**
**FR - A - 1 442 680**
**FR - A - 2 258 050**
**US - A - 1 781 469**

**Lehrbuch der Physik du Professeur Dr. Paul Reis,**
**Verlagsbuchhandlung van Quandt & Händel, 1890, page 294**

(73) Titulaire: **Amstutz, Pierre, 12, rue des Colts-verts,**
**F-78340 Les Clayes sous Bois (FR)**
Titulaire: **Detaint, Jacques, 121, rue de Bondy,**
**F-93250 Villemomble (FR)**

(72) Inventeur: **Amstutz, Pierre, 12, rue des Colts-verts,**
**F-78340 Les Clayes sous Bois (FR)**
Inventeur: **Detaint, Jacques, 121, rue de Bondy,**
**F-93250 Villemomble (FR)**

(74) Mandataire: **Fort, Jacques et al, CABINET**
**PLASSERAUD 84, rue d'Amsterdam, F-75009 Paris (FR)**

**Description**

La présente invention a pour objet un filtre électromécanique passe-bande comportant au moins deux résonateurs mécaniques à état solide couplés, ayant des fréquences de résonance, l'un des résonateurs étant muni de moyens permettant de l'exciter à partir du signal électrique à filtrer et un autre résonateur étant muni de moyens pour fournir un signal électrique de sortie fonction de l'intensité des oscillations.

On sait que les filtres mécaniques ont des caractéristiques qui rendent leur emploi particulièrement intéressant, en particulier un coût modéré en cas de fabrication en grande série, une bonne sélectivité et un caractère passif qui se traduit par une absence complète de consommation.

Les filtres électromécaniques passe-bande sont généralement constitués de résonateurs reliés par des coupleurs métalliques. Les résonateurs, eux-mêmes métalliques, sont associés à des organes de conversion électromécanique, qui sont par exemple des transducteurs piézoélectriques ou piézomagnétiques. On pourra se reporter aux brevets français FR-A-2 175 314 et FR-A-2 258 050, ainsi qu'aux certificats d'addition au premier brevet, pour trouver des exemples de filtres de ce genre ayant des caractéristiques particulièrement favorables.

On peut toutefois reprocher aux filtres électromécaniques connus un certain nombre de défauts. Dans ces filtres connus, les résonateurs sont reliés par des coupleurs solides fixés par divers procédés, tels que soudure, brasure ou collage, qui modifient les caractéristiques des résonateurs, ajustées avant assemblage, dans une mesure difficile à contrôler. De plus, la présence d'un milieu gazeux ambiant entraîne des écarts du fonctionnement de la structure mécanique du filtre par rapport à son modèle théorique, de sorte qu'il est difficile de réaliser un filtre répondant exactement à des caractéristiques fixées à l'avance.

La présente invention vise à fournir un filtre électromécanique répondant mieux que ceux antérieurement connus aux exigences de la pratique, notamment en ce qu'il écarte dans une large mesure les inconvénients ci-dessus et évite les inconvénients liés à la présence de coupleurs solidarisés des résonateurs et l'incidence de la contribution relative des coupleurs et de l'atmosphère ambiante.

Dans ce but, l'invention propose notamment un filtre selon le préambule dont le couplage prépondérant entre les résonateurs est effectué par un gaz séparant des faces en regard desdits résonateurs, lesdites faces en regard étant parallèles et à distance faible par rapport aux longueurs d'onde, dans le gaz de couplage, correspondant à la bande.

Alternativement le couplage prépondérant entre les résonateurs est effectué par un liquide séparant des faces en regard desdits résonateurs, lesdites faces en regard étant parallèles et séparées par une distance voisine de $(2n-1)\,\lambda/4$, $\lambda$ étant la longueur d'onde dans le liquide de couplage correspondant à une fréquence à l'intérieur de la bande et n étant un nombre entier.

Les faces en regard sont généralement parallèles. Lorsqu'on cherche à obtenir un couplage important, on adoptera le plus souvent une distance entre les résonateurs aussi faible que possible dans la mesure compatible avec les impératifs de fonctionnement. Mais, dans d'autres cas, notamment si on utilise un liquide de couplage, on peut être amené à adopter une distance nettement plus importante, qu'il peut être souhaitable de choisir voisine de $(2n-1)\,\lambda/4$, $\lambda$ étant la longueur d'onde dans le fluide de couplage pour une fréquence comprise dans la bande et n étant un nombre entier.

On donnera fréquemment aux différents résonateurs des fréquences différentes, pour les mêmes raisons que celles qui font adopter ce choix dans les filtres électromécaniques déjà connus. Dans certains cas, on peut cependant être amené à donner la même fréquence à deux résonateurs ou davantage, surtout lorsque le filtre comporte un nombre de résonateurs supérieur à 2, ce qui est le cas le plus fréquent.

On voit que l'invention utilise un phénomène qui jusqu'à présent était considéré comme parasite. La réalisation matérielle du filtre devra évidemment être telle que les transmissions d'énergie vibratoire par d'autre voies que le couplage assuré par l'air soient minimisées. Ceci doit être le cas, particulièrement en ce qui concerne la transmission d'énergie par les supports. Dans des cas particuliers, on pourra cependant utiliser, complémentairement, un couplage mécanique classique entre certains résonateurs du filtre pour introduire dans la réponse des pointes d'affaiblissement infini.

L'invention sera mieux comprise à la lecture de la description qui suit de modes particuliers de réalisation, donnés à titre d'exemples non limitatifs. La description se réfère aux dessins qui l'accompagnent, dans lesquels:

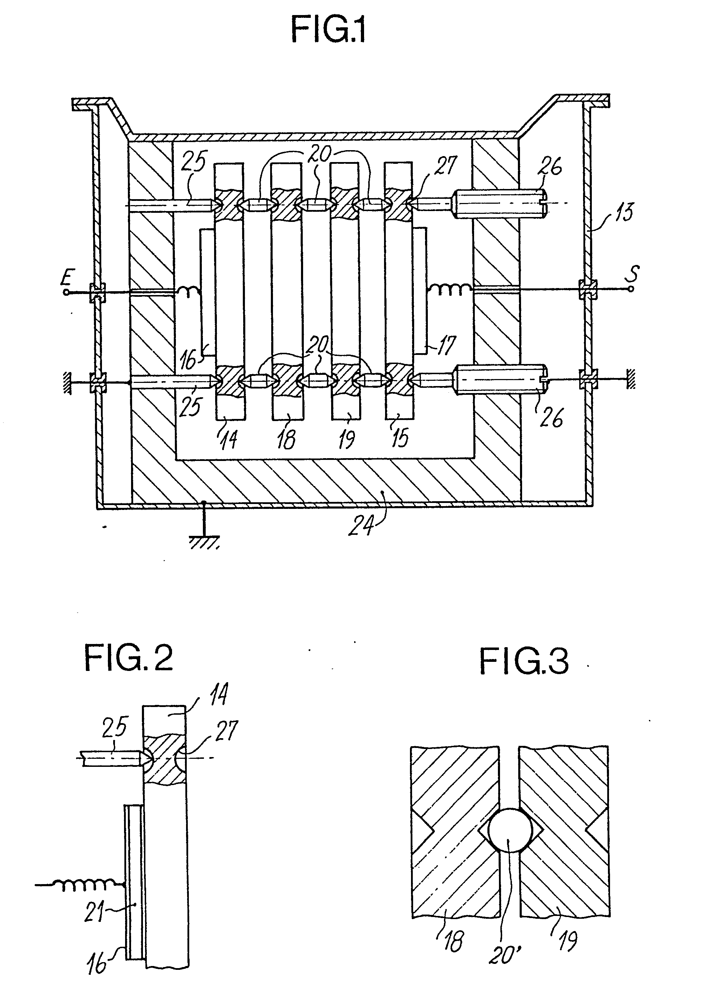

– la Figure 1 est un schéma de principe d'un filtre constituant un premier mode de réalisation, montré en coupe;

– dont la Fig. 1A montre un exemple de courbe de réponse;

– la Figure 2 est une vue à grande échelle montrant un détail de la Figure 1;

– la Figure 3 est un schéma à grande échelle montrant une variante des Figures 1 et 2;

– la Figure 4 montre schématiquement un filtre constituant un autre mode de réalisation de l'invention, en perspective;

– les Figures 5 et 6 sont respectivement un schéma en perspective et un schéma électrique d'un filtre constituant un autre mode encore de réalisation de l'invention;

– les Figures 7 et 8 montrent schématiquement deux dispositifs constituant deux autres variantes encore;

– la Figure 9 est un schéma faisant apparaître le mode de vibration des résonateurs du dispositif de la Figure 8.

Dans tous les modes de réalisation qui seront maintenant décrits, le filtre suivant l'invention peut être regardé comme comportant un résonateur d'entrée 14, associé à un transducteur d'entrée 16 qui reçoit le signal à filtrer et excite la vibration du résonateur 14, et un résonateur de sortie 15 muni d'un transducteur 17 fournissant le signal de sortie filtré. Des résonateurs supplémentaires peuvent être interposés entre les résonateurs d'entrée et de sortie 14 et 15. Le couplage entre résonateurs successifs est assuré par le fluide qui occupe au moins une fraction de l'espace séparant deux parois ou faces en regard de ces résonateurs. Les moyens permettant de retenir les résonateurs en place doivent évidemment être choisis de façon à minimiser les couplages par voie autre que les ondes dans le fluide.

Chaque résonateur est en un ou plusieurs matériaux choisis en tenant compte des impératifs particuliers à respecter pour une application donnée, par exemple une fréquence de résonance très stable ou une surtension élevée. On choisira en général le mode de vibration et la géométrie du résonateur pour avoir un transfert d'énergie élevé entre fluide et résonateur et/ou pour limiter le rayonnement latéral.

Les transducteurs 16 et 17 seront avantageusement choisis d'un type assurant un bon rendement de conversion. On peut notamment utiliser des transducteurs à effet piézoélectrique, électrostrictif, piézomagnétique ou magnétostrictif. Si les transducteurs sont à excitation piézoélectrique, on pourra les constituer, en totalité ou en partie, d'un solide présentant l'effet piézoélectrique, tel que quartz, tantalate de lithium, niobate de lithium ou combinaison de ces matériaux. Des moyens d'adaptation d'impédance pourront être prévus entre les transducteurs 16 et 17 et les lignes de transmission de signal auxquelles ils se raccordent.

Le mode de réalisation de l'invention illustré en figure 1 utilise des résonateurs à vibrations transversales, placés dans une enceinte 13 occupée par le fluide de couplage. Les résonateurs 14 et 15 ont la même constitution et sont associés à des transducteurs 16 et 17 de même type. Le résonateur 14 par exemple (figure 2) est constitué par un disque d'alliage métallique, tel que l'alliage «DURINVAL C» des Aciéries d'Imphy. Le transducteur associé 16 est constitué par un disque 21 de céramique piézoélectrique de plus faible diamètre, relié mécaniquement et électriquement à une face du disque 14. Par un choix approprié de la céramique et un traitement thermique de l'alliage, on peut réduire la dérive thermique en fréquence du résonateur à une valeur très faible, de quelques $10^{-6}$/°C. Les électrodes d'excitation du transducteur 16 sont constituées de couches métalliques minces déposées sur les faces opposées du matériau céramique piézoélectrique. Une de ces électrodes est en contact avec le disque métallique formant résonateur, dont elle est solidarisée par collage ou soudure. L'autre électrode 16 est reliée par un conducteur fin et souple à la ligne d'entrée.

Les résonateurs 14 et 15 sont portés par un support 24, par l'intermédiaire de moyens prévus pour éviter de constituer un couplage mécanique et pour ne pas gêner la vibration des résonateurs en flexion. Dans le mode de réalisation des figures 1 et 2, les moyens de fixation comportent des tiges 25 solidaires du support et prenant appui sur le résonateur 14 en des points répartis le long d'un cercle nodal de ce dernier. Des encoches 27 sont avantageusement ménagées dans les résonateurs pour recevoir la partie terminale des tiges 25 et des vis 26.

Les connexions électriques nécessaires sont, d'une part, constituées par le support 24 mis à la masse et, d'autre part, par les fils fins reliant les lignes d'entrée et de sortie aux électrodes correspondantes des transducteurs 16 et 17.

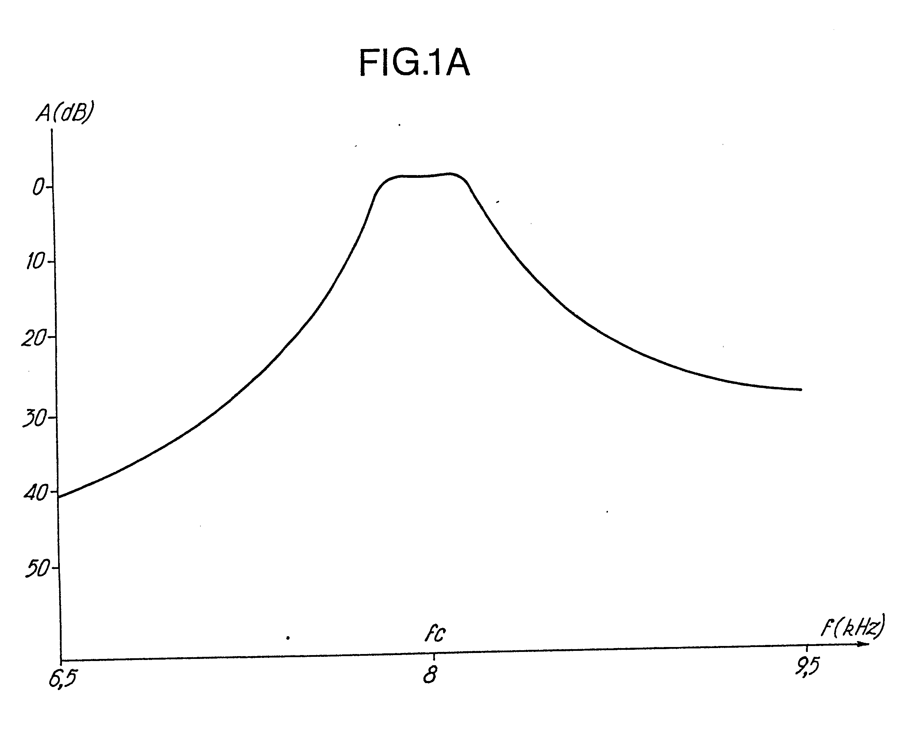

Le mode de réalisation de la figure 1 comporte des résonateurs supplémentaires, au nombre de deux, interposés entre les résonateurs 15 et 16. Ces résonateurs 18 et 19 sont maintenus en place par des entretoises 20 reliées entre elles, qui fixent l'écartement entre résonateurs successifs, s'appuyant sur ces résonateurs en des points répartis sur un cercle nodal. Des encoches supplémentaires sont avantageusement prévues dans les résonateurs pour recevoir ces aiguilles. Dans la variante de réalisation illustrée en figure 3, où les organes correspondant à ceux de la figure 1 portent le même numéro de référence, les aiguilles sont remplacées par des billes 20', par exemple au nombre de trois situées en des points espacés de 20°. Cette dernière solution est particulièrement intéressante dans le cas où on cherche à maintenir une distance faible entre deux résonateurs adjacents.

Le filtre montré en figure 1 utilise des résonateurs couplés uniquement par le fluide dans lequel ils baignent. Mais on peut également réaliser un filtre comprenant, d'une part, des résonateurs couplés par fluide, d'autre part, des résonateurs couplés par des organes d'autre type, de façon à obtenir une caractéristique globale de filtrage particulière, notamment un affaiblissement infini pour des fréquences qui restent finies. La courbe de réponse (affaiblissement en amplitude en fonction de la fréquence) illustrée à titre d'exemple en Figure 1A correspond à un filtre à deux résonateurs, séparés par une lame d'air de 1 mm.

On voit que l'invention permet de réaliser un filtre robuste, facile à assembler et à régler, de prix de revient bas, trouvant de nombreux domaines d'application, notamment en télécommunication.

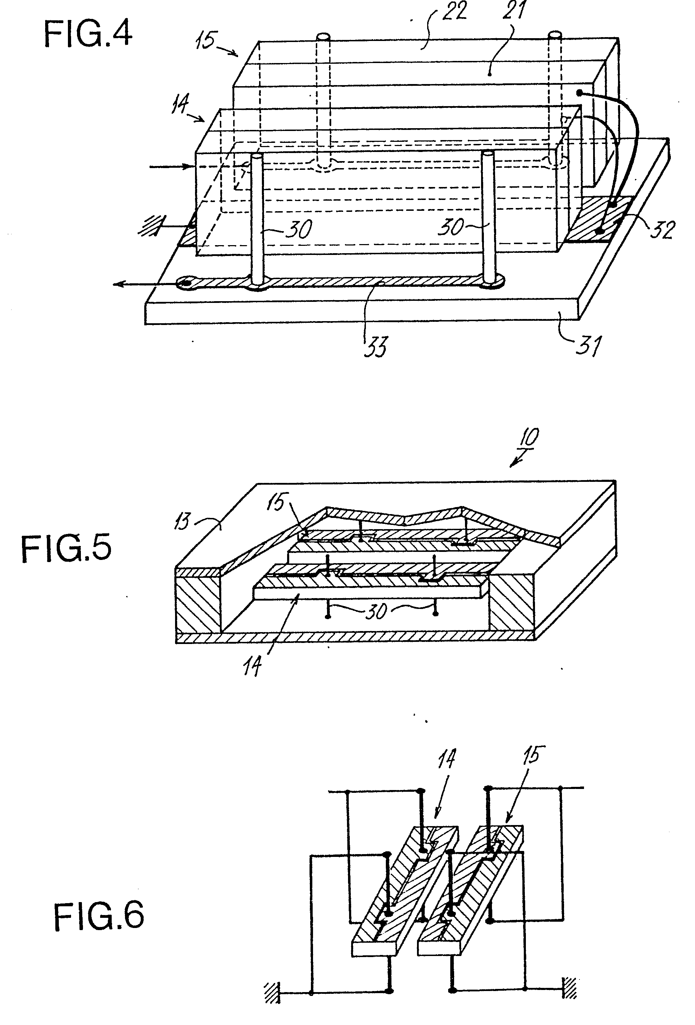

L'invention est par ailleurs susceptible de nombreux modes de réalisation. Celui qui est représenté en Figure 4 comporte deux résonateurs 14 et 15 seulement. Ces résonateurs sont constitués par deux barreaux vibrant en mode de flexion, situés à faible distance l'un de l'autre et couplés par le fluide qui est contenu dans une enceinte non représentée. A titre d'exemple, on peut réaliser un filtre à partir de barreaux de 30 × 5 ×

0,6 mm pour réaliser un filtre destiné à assurer un filtrage dans la bande 10 kHz à 10,5 kHz. Chaque barreau peut être porté par deux tiges 30 soudées sur un support 31 et reliées au barreau correspondant en des zones nodales de celui-ci. Le support 31 peut être une carte de circuit imprimé portant une plage 32 de liaison à la masse et des pistes, telles que 33, de raccordement aux lignes d'entrée et de sortie. Chaque résonateur peut être de type bimorphe comportant soit deux lames de céramique piézo-électrique, soit une lame en alliage métallique 22 solidarisée d'une lame céramique 21 dont les deux faces opposées métallisées constituent électrodes. Dans le premier cas, les polarisations des lames sont opposées de façon que, lors de l'excitation par un champ alternatif dû à l'application de la tension d'entrée sur les électrodes extérieures, on obtienne une vibration en flexion. Si des résonateurs intermédiaires sont prévus, ils peuvent être fixés de la même façon que les résonateurs 14 et 15, mais ils ne comportent que la lame 22.

Dans le mode de réalisation montré en figures 5 et 6, le filtre comprend deux résonateurs à quartz 14 et 15 de constitution classique, d'un type fréquemment utilisé pour des fréquences allant de quelques kHz à 50 kHz environ. Le mode de vibration de ces résonateurs est la flexion longueur-largeur. Le couplage est assuré par des faces perpendiculaires au déplacement principal de flexion. Chaque résonateur porte deux demi-électrodes supérieures et deux demi-électrodes inférieures reliées à des tiges support 30 d'amenée de courant, comme indiqué schématiquement sur la figure 6. L'avantage de ce type de résonateur est de donner une surtension élevée, de quelques $10^4$, et d'avoir une grande insensibilité aux effets de la température. La même géométrie peut être utilisée en adoptant, comme matériau piézoélectrique, du tantalate de lithium au lieu de quartz.

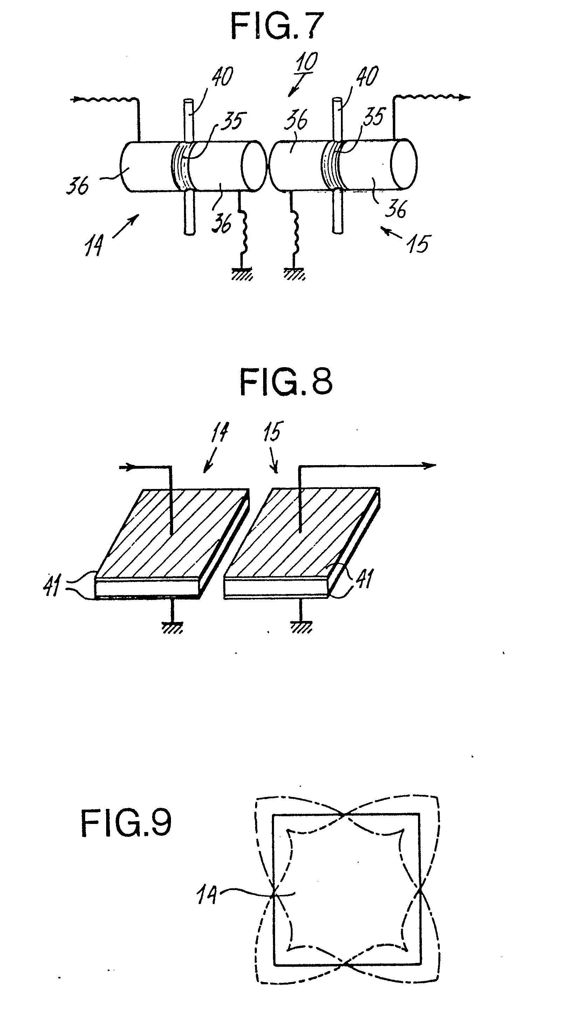

Les résonateurs peuvent être prévus pour vibrer en des modes autres que de flexion. A titre d'exemple, la figure 7 montre un filtre comportant deux résonateurs 14 et 15 constitués chacun par un disque de matériau piézoélectrique (par exemple céramique piézoélectrique ou niobate de lithium 35) fixé entre deux blocs 36 d'alliage métallique. Chaque résonateur 14 ou 15 est fixé à un support non représenté par au moins deux tiges 40 solidarisées du disque 35. Le couplage s'effectue alors en bout, le résonateur pouvant avoir une section droite quelconque, par exemple cylindrique comme indiqué sur la figure 7.

Le filtre de la figure 7 peut être simplifié, chaque résonateur se limitant à un barreau de matériau piézoélectrique dont les deux faces opposées sont métallisées. L'une des faces de la céramique est alors mise à la masse, tandis que l'autre est reliée soit à la ligne d'entrée, soit à la ligne de sortie.

On voit que, là encore, les faces en regard des résonateurs 14 et 15 sont portées au même potentiel (potentiel de masse) ce qui évite tout couplage électrostatique.

Comme dans les modes de réalisation précédents, des résonateurs intermédiaires peuvent être intercalés entre les résonateurs 14 et 15. Ils sont alors montés dans le boîtier qui contient les résonateurs terminaux 14 et 15 par des tiges supplémentaires 40.

Dans le mode de réalisation montré en figure 8, les résonateurs 14 et 15 sont d'un type connu vibrant en mode de cisaillement plan. Ces résonateurs sont par exemple constitués de plaques de matériau piézoélectrique, tel que le quartz, revêtues sur deux faces opposées, transversales aux faces en regard des résonateurs, de couches métalliques 41 constituant électrodes. Les déformations de chaque plaque sont alors du type représenté, sous forme très accentuée, sur la figure 9. Sur ces électrodes sont fixées, en un point nodal, les tiges de montage des plaques dans un boîtier non représenté. Des plaques résonantes, non reliées aux lignes d'entrée et de sortie, peuvent être intercalées entre les précédentes pour constituer des résonateurs supplémentaires.

Dans la plupart des cas, le fluide de couplage sera un gaz; bien que l'utilisation d'un gaz lourd, tel qu'un «fréon» puisse être avantageuse pour élargir la bande passante, on choisira fréquemment l'air à la pression atmosphérique, qui permet d'éviter un boîtier étanche sans inconvénient sérieux: en effet, les variations naturelles de la pression atmosphérique n'introduisent que de faibles variations d'atténuation.

L'utilisation d'un liquide comme fluide de couplage peut toutefois être avantageuse, notamment pour coupler par viscosité des résonateurs vibrant selon un mode à caractère transverse, avec amortissement, et pour coupler par une faible quantité de fluide des résonateurs: on dispose alors d'un paramètre supplémentaire, constitué par cette quantité, qui permet un réglage du couplage.

**Revendications**

1. Filtre électromécanique passe-bande comportant au moins deux résonateurs mécaniques à état solide (14, 15) couplés, ayant des fréquences de résonance, l'un des résonateurs étant muni de moyens permettant de l'exciter à partir du signal électrique à filtrer et un autre résonateur étant muni de moyens pour fournir un signal électrique de sortie fonction de l'intensité des oscillations, caractérisé en ce que le couplage prépondérant entre les résonateurs est effectué par un gaz séparant des faces en regard desdits résonateurs, lesdites faces en regard étant parallèles et à distance faible par rapport aux longueurs d'onde, dans le gaz de couplage, correspondant à la bande et les résonateurs étant montés de façon à présenter des oscillations qui laissent subsister le parallélisme desdites faces en regard.

2. Filtre électromécanique passe-bande comportant au moins deux résonateurs mécaniques à état solide (14, 15) couplés, ayant des fréquences de résonance, l'un des résonateurs étant muni de moyens permettant de l'exciter à partir du signal électrique à filtrer et un autre résonateur étant muni de moyens pour fournir un signal électrique de sortie fonction de l'intensité des oscillations,

caractérisé en ce que le couplage prépondérant entre les résonateurs est effectué par un liquide séparant des faces en regard desdits résonateurs, lesdites faces en regard étant parallèles et séparées par une distance voisine de $(2n-1) \cdot \lambda/4$, $\lambda$ étant la longueur d'onde dans le liquide de couplage correspondant à une fréquence à l'intérieur de la bande et n étant un nombre entier.

3. Filtre suivant la revendication 1 ou 2, caractérisé en ce que les résonateurs (14, 15) sont d'un type à vibrations transversales, le transfert d'énergie ayant alors lieu par effet de viscosité, ou d'un type à vibrations longitudinales, imposant des oscillations de compression et d'expansion au fluide.

4. Filtre suivant l'une quelconque des revendications précédentes, caractérisé en ce que les moyens d'excitation et de fourniture d'un signal électrique de sortie sont des transducteurs à effet magnétostrictif, électrostrictif, piézoélectrique ou piézomagnétique.

5. Filtre suivant l'une quelconque des revendications précédentes, caractérisé en ce que les résonateurs sont portés par un support commun, par l'intermédiaire de moyens qui n'introduisent pas de couplage mécanique prépondérant comparé au couplage par le fluide.

6. Filtre suivant l'une quelconque des revendications 1 à 4, caractérisé en ce que les résonateurs, du type à vibrations transversales, sont constitués par des plaques ou disques métalliques parallèles, supportés par des moyens répartis le long d'une ligne nodale des résonateurs.

7. Filtre suivant la revendication 6, caractérisé en ce que les moyens supportant les résonateurs comportent des tiges reliant les résonateurs munis de moyens d'excitation et de fourniture de signal électrique à un support commun et des entretoises situées entre les faces en regard des résonateurs successifs et fixant la distance entre faces en regard desdits résonateurs.

8. Filtre suivant l'une quelconque des revendications précédentes, caractérisé en ce que les résonateurs sont enfermés dans un boîtier étanche contenant le fluide de couplage.

**Claims**

1. Band-pass electromechanical filter comprising at least two coupled solid state mechanical resonators (14, 15) which have resonance frequencies, one of the resonators being provided with means for energizing it with the electric signal to be filtered and another resonator being provided with means for delivering an output electric signal which is in relation with the value of the oscillations,

characterized in that the main coupling between the resonators is by a gas which separates confronting surfaces of said resonators, said confronting surfaces being parallel and at a mutual distance which is low as compared with the wavelength within the coupling gas corresponding to the band and the resonators being so arranged that they have oscillations during which said confronting surfaces remain parallel.

2. Band-pass electromechanical filter comprising at least two coupled solid state mechanical resonators (14, 15) which have resonance frequencies, one of the resonators being provided with means for energizing it with the electric signal to be filtered and another resonator being provided with means for delivering an output electric signal which is in relation with the value of the oscillations,

characterized in that the main coupling between the resonators is by a liquid which separates confronting surfaces of said resonators, said confronting surfaces being parallel and separated by a distance which is approximately equal to $(2n-1) \cdot \lambda/4$, wherein $\lambda$ is the wavelength in the coupling liquid which corresponds to a frequency within the band and n is an integer.

3. Filter according to claim 1 or 2, characterized in that the resonators (14, 15) are of a type having transversal vibrations, energy transfer then occurring by viscosity, or of a type having longitudinal vibrations, which cause compression and expansion oscillations to the fluid.

4. Filter according to any one of the preceding claims, characterized in that the means for energization and for delivery of an output electric signal are magnetostrictive, electrostrictive, piezoelectric or piezomagnetic transducers.

5. Filter according to any one of the preceding claims, characterized in that the resonators are carried by a common support through means which do not introduce mechanical coupling prevailing over fluid coupling.

6. Filter according to any one of the claims 1–4, characterized in that the resonators, of the type having transversal vibrations, consist of parallel metal plates or disks, carried by means distributed along a nodal line of the resonators.

7. Filter according to claim 6, characterized in that the means which support the resonators comprise rods connecting those resonators which are provided with means for energization and for delivery of an electric signal to a common support and spacers located between the mutually confronting surfaces of the successive resonators and defining the distance between confronting surfaces of said resonators.

8. Filter according to any one of the preceding claims, characterized in that the resonators are contained in a fluid-tight casing which contains the coupling fluid.

**Patentansprüche**

1. Elektromechanisches Bandpassfilter mit wenigstens zwei mechanischen, fest gekoppelten Resonatoren (14, 15), die Resonanzfrequenzen aufweisen, wobei einer der Resonatoren mit Mitteln, die es erlauben, von den zu filternden elektrischen Signalen aus angeregt zu werden, und ein anderer Resonator mit Mitteln zum Liefern eines elektrischen Ausgangssignales in Funktion von der Intensität der Oszillationen, ausgestattet ist, dadurch gekennzeichnet, dass die ausschlaggebende Kopplung zwischen den Resonatoren von einem Gas, getrennt von gegenüberliegenden Seiten der Resonatoren, bewirkt wird, wobei diese gegenüberliegenden Seiten parallel und in einem geringeren Abstand in bezug auf die Wellenlängen in dem Kopplungsgas dem Band entsprechend angeordnet sind, und wobei Resonatoren montiert sind, um Oszillationen hervorzurufen, die die Parallelität der gegenüberliegenden Flächen bestehen lassen.

2. Elektromechanischer Bandpassfilter mit wenigstens zwei mechanischen, fest gekoppelten Resonatoren (14, 15), die Resonanzfrequenzen aufweisen, wobei einer der Resonatoren mit Mitteln die es erlauben, von den zu filternden elektrischen Signalen aus angeregt zu werden, und ein anderer Resonator, mit Mitteln zum Liefern eines elektrischen Ausgangssignales in Funktion von der Intensität der Oszillationen, ausgestattet ist dadurch gekennzeichnet, dass die ausschlaggebende Kopplung zwischen den Resonatoren von einer Flüssigkeit, getrennt von gegenüberliegenden Seiten der Resonatoren, bewirkt wird, wobei diese gegenüberliegenden Seiten parallel und voneinander in einem Abstand nahe $(2n-1) \cdot \lambda/4$ getrennt sind, wobei $\lambda$ die Wellenlänge in der Kopplungsflüssigkeit entsprechend einer Frequenz innerhalb des Bande und n eine ganze Zahl ist.

3. Filter nach den Ansprüchen 1 oder 2, dadurch gekennzeichnet, dass die Resonatoren (14, 15) vom Transversalschwingungstyp sind, wobei der Transfer von Energie durch die Wirkung der Viskosität geschieht, oder vom Longitudinalschwingungstyp sind, aufgezwungen von Oszillationen der Kompression und der Expansion des Fluides.

4. Filter nach einem der vorangehenden Ansprüche, dadurch gekennzeichnet, dass die Mittel der Anregung und der Aufbringung des elektrischen Ausgangssignales Transduktoren mit magnetostriktiver, elektrostriktiver, piezoelektrischer oder piezomagnetischer Wirkung sind.

5. Filter nach einem der vorangehenden Ansprüche, dadurch gekennzeichnet, dass die Resonatoren von einem gemeinsamen Support durch die Zwischenschaltung von Mitteln, die keine mechanische stärkere Kupplung aufbringen, verglichen mit der Kopplung durch das Fluid, getragen sind.

6. Filter nach einem der Ansprüche 1 bis 4, dadurch gekennzeichnet, dass die Resonatoren des Typs der Transversalschwingungen von parallelen metallischen Platten oder Scheiben, verteilt entlang einer Knotenlinie der Resonatoren, gebildet sind.

7. Filter nach Anspruch 6, dadurch gekennzeichnet, dass die Tragmittel der Resonatoren Bolzen, die die Resonatoren verbinden, versehen mit Mitteln zur Erregung und Lieferung des elektrischen Signales an einem gemeinsamen Support, und Spannbolzen, die zwischen den gegenüberliegenden Seiten folgender Resonatoren angeordnet sind und den Abstand zwischen den gegenüberliegenden Seiten der Resonatoren festlegen, umfassen.

8. Filter nach einem der vorangehenden Ansprüche, dadurch gekennzeichnet, dass die Resonatoren in einem dichten Gehäuse, welches das Kupplungsfluid enthält, eingeschlossen sind.

# FIG.1

# FIG.2

# FIG.3

# FIG.1A

FIG.4

FIG.5

FIG.6

## FIG.7

## FIG.8

## FIG.9